# EUROPÄISCHE PATENTSCHRIFT

(11) **EP 0 515 438 B1**
(45) Veröffentlichungstag und Bekanntmachung des Hinweises auf die Patenterteilung: **18.05.1994**
(21) Anmeldenummer: 91903600.4
(22) Anmeldetag: 08.02.1991
(51) Int. Cl.: H03M 1/36, G11B 5/596

(54) **VERFAHREN ZUM UMSETZEN EINER ANALOGEN SPANNUNG IN EINEN DIGITALWERT**
PROCESS FOR CONVERTING AN ANALOG VOLTAGE TO A DIGITAL VALUE
PROCEDE DE CONVERSION D'UNE TENSION ANALOGIQUE EN VALEUR NUMERIQUE

(30) Priorität: 16.02.1990 DE 4005037
(43) Veröffentlichungstag der Anmeldung: 02.12.1992
(73) Patentinhaber: Siemens Nixdorf Informationssysteme Aktiengesellschaft, 33102 Paderborn (DE)
(72) Erfinder: HANTKE, Horst, D-1000 Berlin 45 (DE)
(74) Vertreter: Fuchs, Franz-Josef, Dr.-Ing.
(86) Internationale Anmeldenummer: EP9100242
(87) Internationale Veröffentlichungsnummer: WO9112668

(56) Entgegenhaltungen:
- WO-A-88/03728
- IEEE 1980 IECI Proceedings, Philadelphia, Pennsylvania US, 17-20 March 1980, "Application of Mini- and Microcomputers", R.Lumia: "A low cost optical data acquisition system", pages 299-301
- Electronic Engineering, September 1970, "Applications" ITT Semiconductors: Peak-level grading system, pages 96-99
- IBM Technical Disclosure Bulletin, vol.31, no.6, November 1988 (Armonk, NY, US) "Position Error Signal Read Logic", pages 95-96

## Beschreibung

Die Erfindung betrifft ein Verfahren zum Umsetzen einer analogen Spannung in einen Digitalwert, nach dem Oberbegriff des Patentanspruchs 1. Ferner betrifft die Erfindung eine Schaltungsanordnung zum Durchführen des vorgenannten Verfahrens.

Aus Electronic Engineering, September 1970, "Application", Seite 96 bis 97, bzw. aus IEEE 1980 IECI Proceedings, Philadelphia, Pennsylvania, US, 17. bis 20. März, 1980, "Applications of Mini and Micro Computers", R. Lumia: "Low Cost Optical Data Acquisition System", Seiten 299 bis 301, ist ein Verfahren zum Umsetzen einer analogen Spannung in einen Digitalwert bekannt. Bei den bekannten Verfahren werden bistabile bzw. tristabile Speicherelemente eingesetzt, um die Spitzenwerte von Analogsignalen innerhalb eines vorgegebenen Zeitintervalls zu detektieren. Diese Spitzenwerte werden in den Speicherelementen digital gespeichert. Zu Beginn einer Analog/Digital-Umsetzung werden die Speicherelemente durch ein Signal in einen vorgegebenen definierten Zustand gesetzt.

Aus der WO-A-88/03728 ist weiterhin ein Verfahren zum Umsetzen einer analogen Spannung in einen Digitalwert bekannt. Bei dem dort beschriebenen Verfahren ist eine Logikschaltung vorgesehen, mit der der Zeitpunkt einer Änderung der analogen Spannung festgestellt werden kann. Hierzu werden Verzögerungs-Bauelemente eingesetzt, die mit den Ausgängen von Komparator-Bausteinen verbunden sind. Eine Änderung der analogen Spannung innerhalb der Verzögerungszeit der Verzögerungs-Bauelemente erzeugt ein Taktsignal, das einen Speicherschaltkreis steuert, der daraufhin den aktuellen Digitalwert speichert, der der anliegenden analogen Spannung entspricht. Der Zeitpunkt des Auftretens eines Extremwerts in der analogen Spannung kann mit diesem bekannten Verfahren bzw. mit dieser bekannten Schaltungsanordnung nicht erkannt werden.

Ein weiteres Umsetzverfahren ist in Halbleiter-Schaltungstechnik, U. Tietze, Ch. Schenk, 8. Auflage, 1986, S. 761 bis 765, beschrieben. Bei diesem auch als Parallelverfahren bezeichneten Verfahren wird die umzusetzende Spannung in Komparatorbausteinen gleichzeitig mit einer großen Zahl von Referenzspannungen verglichen und festgestellt, zwischen welchen zwei Referenzspannungen die Spannung liegt. Der diesen Referenzspannungen zugewiesene Digitalwert wird als binäres Umsetzergebnis ausgegeben. Auf diese Weise erhält man den Digitalwert in einem einzigen Schritt. Dadurch ist die Umsetzzeit im Vergleich zu anderen Analog-Digital-Umsetzverfahren sehr kurz, so daß auch schnell sich ändernde Spannungswerte erfaßt werden können.

Beim bekannten Verfahren werden die durch Vergleich in Komparatorbausteinen ermittelten Binärwerte in flankengetriggerten D-Flip-Flops zwischengespeichert. Diese übernehmen mit ansteigender Flanke eines Freigabesignals die an den Ausgängen der Komparatorbausteine nach dem Vergleich vorliegenden Binärwerte und speichern diese bis zur nächsten Anstiegsflanke des Freigabesignals. Dadurch wird sichergestellt, daß ein nachfolgender Codewandler, der aus den gespeicherten Binärwerten schließlich den Digitalwert erzeugt, für eine Taktperiode des Freigabesignals konstante Eingangssignale erhält, was Voraussetzung für die Ermittlung richtiger Zahlenwerte ist.

In zahlreichen Anwendungsfällen ist es erforderlich, bei einer sich schnell und aperiodisch ändernden Spannung einen Extremwert zu erfassen, d.h. den Maximalwert oder den Minimalwert, und diesen als Digitalwert auszugeben. Zum Beispiel bei der Verarbeitung von Servosignalen bei Plattenspeichersystemen sind die Spitzenwerte von vier Spursignalen zu bestimmen, welche die Spurmittellage eines Servokopfes nach dem bekannten Quadratur-Dibit-Verfahren definieren. Werden diese Extremwerte nicht exakt erfaßt, so entstehen zwangsläufig Spurabweichungen, die nicht ohne weiteres ausregelbar sind.

Wenn beim bekannten Verfahren ein Spitzenwert in die Zeit zwischen zwei Anstiegsflanken des Freigabesignals fällt, so kann dieser Wert nicht als Digitalwert ausgegeben werden, da nicht die den Spitzenwert abbildenden Binärwerte der Komparatorbausteine gespeichert werden, sondern die im Augenblick der Anstiegsflanke des Freigabesignals an den Ausgängen der Komparatorbausteine anliegenden Binärwerte. Wollte man mit dem bekannten Verfahren nur den Spitzenwert der Spannung in einen Digitalwert umsetzen, so müßte zunächst der Zeitpunkt des Spitzenwerts genau ermittelt werden, um die Umwandlung zum richtigen Zeitpunkt starten zu können. Dies würde einen erheblichen Aufwand an Analogelektronik erfordern und auch die Genauigkeit, mit der der Spitzenwert erfaßt werden könnte, beeinträchtigen, denn die hierfür benötigten Kondensatoren würden zwangsläufig den Verlauf der Spannung verändern, selbst wenn sie kleine Kapazitäten hätten.

Es ist Aufgabe der Erfindung, ein Verfahren und eine Schaltungsanordnung anzugeben, mit dem bzw. mit der der Zeitpunkt des Auftretens eines Extremwerts in der analogen Spannung festgestellt werden kann.

Diese Aufgabe wird durch ein Verfahren nach dem Patentanspruch 1 bzw. durch eine Schaltungsanordnung nach Patentanspruch 6 gelöst.

Die Erfindung beruht auf der Erkenntnis, daß einem in einem Zeitabschnitt auftretenden Extremwert einer Spannung immer Spannungswerte vorangehen, die niedriger oder höher als der Extremwert sind, was davon abhängt, ob der Extremwert ein Maximalwert oder ein Minimalwert ist. Dies gilt auch für Impulse, die sehr steile Flanken haben. Beim Vergleich der Spannung mit den Referenzspannungen werden die Augenblickswerte der Spannung in Form von Binärwerten abgebildet. Durch das Setzen der Speicherbausteine auf einen definierten Anfangszustand, d.h. auf die Binärwerte 0 oder 1, deren Bedeutung später noch näher erläutert wird, werden sie derart aktiviert, daß sie zwar in den anderen Binärzustand kippen können, jedoch aus diesem bis zum Auftreten des nächsten Freigabesignals nicht mehr in den Anfangszustand zurückkehren.

Der Wechsel eines Binärzustands eines Speicherbausteins bedeutet dann, daß die Spannung die dem Speicherbaustein zugeordnete Referenzspannung mindestens einmal überschritten bzw. unterschritten hat. Die Speicherbausteine lassen sich somit in eine Gruppe mit dem Binärwert des Anfangszustands und eine Gruppe mit dem anderen Binärwert einteilen. Der Extremwert der Spannung liegt dann zwischen den Referenzspannungen der beiden benachbarten Speicherbausteine mit unterschiedlichem Binärwert und wird durch das Binärwertmuster der Speicherbausteine abgebildet. Die gespeicherten Binärwerte werden dann in den Digitalwert umgewandelt.

Mit dem erfindungsgemäßen Verfahren können Maximalwerte und Minimalwerte erfaßt und umgesetzt werden. Als Beispiel sei angenommen, daß beim Vergleich der Spannung mit den Referenzspannungen jeweils ein Binärwert 1 erzeugt wird, wenn die Spannung größer als die jeweilige Referenzspannung ist. Werden nun die Speicherbausteine zu Beginn der Umsetzung durch das Freigabesignal auf den Anfangszustand O gesetzt, so kippen diejenigen Speicherbausteine in den Binärzustand 1, für die beim Vergleich eine größere Spannung als die jeweilige Referenzspannung festgestellt worden ist. Alle anderen Speicherbausteine verharren in ihrem Anfangszustand mit dem Binärwert 0. Durch anschließende Umwandlung der gespeicherten Binärwerte in einen Zahlenwert, z.B. durch einen Prioritätsdecoder oder einen anderen Codewandler, entsteht ein Digitalwert, der den Spitzenwert der Spannung angibt. Die im Beispiel verwendeten Logikpegel werden im folgenden als positive Logik bezeichnet. Selbstverständlich ist es auch möglich, die Erfindung mit hierzu inversen Logikpegeln zu realisieren, ohne daß vom Erfindungsgedanken abgewichen wird.

Soll nach dem erfindungsgemäßen Verfahren ein Minimalwert erfaßt und als Digitalwert ausgegeben werden, so muß beim oben genannten Beispiel mit positiver Logik lediglich der Anfangszustand aller Speicherbausteine zu Beginn der Umsetzung auf den Binärwert 1 gesetzt werden. Nach Ablauf des Zeitabschnitts, in dem der Minimalwert festgestellt werden soll, liegt an den Speicherbausteinen das Umsetzergebnis als inverses Binärmuster vor. Bei der anschließenden Umwandlung in den Digitalwert kann die Invertierung aufgehoben werden, beispielsweise indem die Binärwerte invertiert oder der inverse Digitalwert gebildet wird.

Die umzusetzende Spannung kann einen aperiodischen Verlauf mit mehreren Nebenmaxima oder -minima haben, ohne daß das Umsetzergebnis beeinträchtigt wird. Da ferner keine speichernden Bauelemente wie beispielsweise Kondensatoren zur Extremwertbildung verwendet werden müssen, kann durch das neue Verfahren eine hohe Umsetzgeschwindigkeit und eine hohe Auflösung erreicht werden.

Bei einer bevorzugten Ausführungsform der Erfindung ist vorgesehen, daß der Binärwert im jeweiligen Speicherbaustein abhängig von einem Fenstersignal gespeichert wird. Durch diese Maßnahme läßt sich der Zeitbereich, in dem der Extremwert erfaßt und umgesetzt wird, auf einen als Zeitfenster bezeichneten Bereich einengen, der innerhalb der Zeit zwischen zwei aufeinander folgenden Freigabesignalen liegt. Dadurch wird es möglich, störende Spannungswerte, die außerhalb dieses Zeitfensters auftreten können, wirkungsvoll auszublenden.

Bei einer weiteren vorteilhaften Ausgestaltung der Erfindung werden der beim jeweiligen Vergleich erzeugte Binärwert und der invertierte gespeicherte Binärwert disjunktiv miteinander verknüpft. Danach werden die Ergebnisse der Verknüpfungen für alle Vergleiche konjunktiv zu einem Synchronisationssignal verknüpft.

Durch diese Maßnahme kann an Hand des Synchronisationssignals der Zeitpunkt des Auftretens des Extremwerts festgestellt werden. Dies sei an Hand des Auftretens eines Spitzenwerts innerhalb eines Freigabesignal-Taktintervalls näher erläutert. Solange der Wert der Spannung ansteigt, wird durch den Vergleich der Spannung mit den Referenzspannungen bei positiver Logik ein Speicherbaustein nach dem anderen auf den Binärwert 1 gesetzt. Der beim jeweiligen Vergleich erzeugte Binärwert hat ebenfalls den Wert 1. Fällt die Spannung nach Überschreiten des Spitzenwerts, so wird derjenige Binärwert am Eingang des Speicherbausteins den Wert 0 annehmen, der die dem Extremwert am nächsten kommende Referenzspannung hat, da diese als erste unterschritten wird. Durch die oben genannten logischen Verknüpfungen wird dieser Zustand erkannt und im Synchronisationssignal abgebildet. Analog ist zu verfahren, wenn als Extremwert ein Minimalwert verwendet werden soll.

Durch diese Ausgestaltung der Erfindung wird es möglich, weitere Prozesse wie beispielsweise Verarbeitungs- und Steuerprozesse mit dem Auftreten eines Extremwerts zu synchronisieren.

Eine andere Weiterbildung der Erfindung ist dadurch gekennzeichnet, daß jeder gespeicherte Binärwert mit dem gespeicherten Binärwert mit nächstniedrigerer Referenzspannung und mit dem invertierten gespeicherten Binärwert mit nächsthöherer Referenzspannung konjunktiv verknüpft wird und das Ergebnis für die Umwandlung in den Digitalwert verwendet wird, wobei der gespeicherte Binärwert mit niedrigster Referenzspannung nur mit dem invertierten gespeicherten Binärwert mit nächsthöherer Referenzspannung und der gespeicherte Binärwert mit höchster Referenzspannung nur mit dem gespeicherten Binärwert mit nächstniedrigerer Referenzspannung konjunktiv verknüpft wird.

Infolge von Ungenauigkeiten der Referenzspannungen, hervorgerufen z.B. durch Temperaturdrift der zur Durchführung des Verfahrens benötigten elektronischen Bauelemente sowie infolge unterschiedlicher Laufzeiten der Signale in den Bauelementen, kann es bei der Ermittlung von Spitzenwerten der Spannung vorkommen, daß ein Speicherbaustein mit höherer Referenzspannung bereits in den vom Anfangszustand verschiedenen Binärzustand geschaltet hat, bevor dieser am Ausgang des Speicherbausteins mit nächstniedrigerer Referenzspannung erscheint. Die Folge davon ist, daß das Binärmuster an den Ausgängen aller Speicherbausteine einen falschen Zahlenwert wiedergibt.

Durch die oben genannten Maßnahmen wird ein sogenanntes 1-aus-n-Signal erzeugt. Dies bedeutet, daß unter n Binärwerten, die beim Vergleich der Spannung mit den Referenzspannungen erzeugt werden, nur derjenige als Ergebnis mit Wert 1 ausgegeben wird, dessen Referenzspannung gerade von der Spannung überschritten worden ist. Alle anderen Verknüpfungen haben den Wert 0. Durch diese Art der Verknüpfung wird die Erzeugung falscher Zahlenwerte vermieden, und das Verknüpfungsergebnis kann als zuverlässiger Ausgangswert für die anschlieβende Umwandlung in den Digitalwert verwendet werden.

Eine Schaltungsanordnung zur Durchführung des Verfahrens ist in weiterer Ausbildung der Erfindung dadurch gekennzeichnet, daß die analoge Spannung mehreren Komparatorbausteinen zugeführt wird, die voneinander verschiedene Referenzspannungen haben, mit denen die analoge Spannung verglichen wird, und die abhängig vom jeweiligen Vergleich je einen Binärwert erzeugen, der dem durch das Freigabesignal am Rücksetzeingang steuerbaren bistabilen Speicherbaustein an seinem Setzeingang zugeführt wird, und daß die Ausgangssignale aller Speicherbausteine einem Codewandler zugeführt werden, der sie in einen Digitalwert umwandelt und diesen ausgibt. Als Speicherbausteine können RS-Flip-Flops vorgesehen sein. Sowohl die Komparatorbausteine als auch die Speicherbausteine haben hohe Signalverarbeitungsgeschwindigkeiten. Dadurch können sehr kurze Umsetzungszeiten erreicht und die Extremwerte der Spannung sehr genau ermittelt werden.

Bei einer vorteilhaften Ausführungsform der Erfindung ist zwischen den Komparatorbausteinen und den Speicherbausteinen jeweils ein NAND-Glied vorgesehen, dessen einer Eingang mit dem Ausgang des jeweiligen Komparatorbausteins verbunden ist und dessen anderem Eingang das Fenstersignal zugeführt ist. Durch diese Verknüpfung wird das Zeitfenster realisiert, in dem der Extremwert der Spannung erfaßt werden soll.

Ausführungsbeispiele der Erfindung werden nachstehend an Hand der Zeichnung erläutert. Darin zeigt:
- Fig. 1: eine Schaltungsanordnung zum Umsetzen eines Spitzenwerts einer Eingangsspannung in einen Digitalwert,
- Fig. 2: eine Anwendung der Erfindung bei der Spurregelung eines Plattenspeichersystems in einer Blockdarstellung und
- Fig. 3: eine weitere Schaltungsanordnung zum Umsetzen von Spitzenwerten in Digitalwerte mit verschiedenen Zusatzfunktionen.

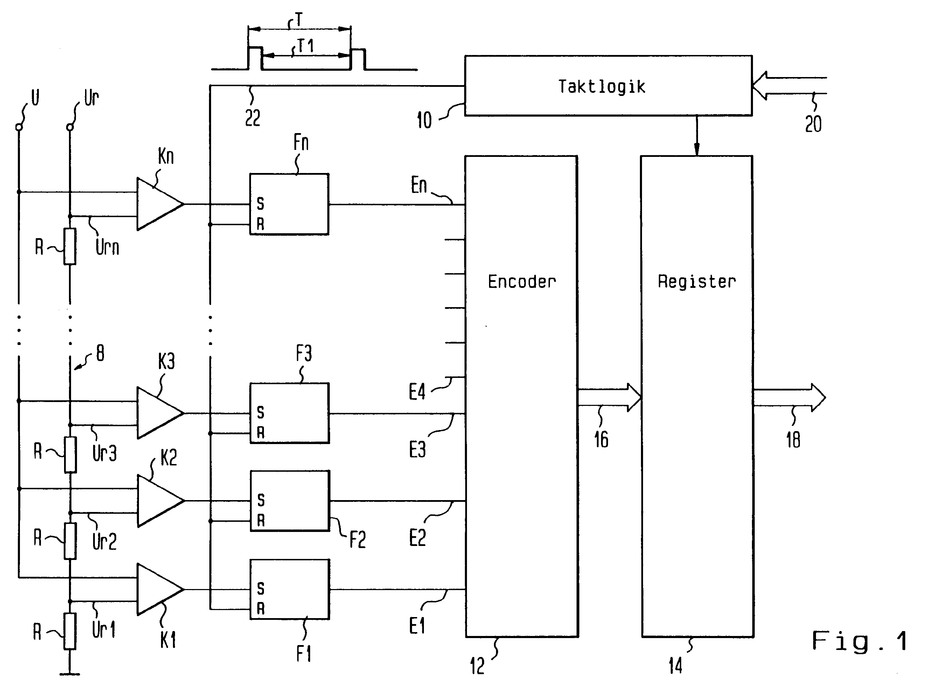

In Fig. 1 ist eine Schaltungsanordnung dargestellt, mit der das erfindungsgemäße Verfahren zum Umsetzen eines Spitzenwerts einer analogen Spannung in einen Digitalwert realisiert werden kann. Für jeden möglichen Digitalwert wird ein Komparatorbaustein benötigt. Im vorliegenden Beispiel werden diese Digitalwerte durch eine achtstellige Binärzahl angegeben. Dies bedeutet, daß 255 Komparatorbausteine K1 bis Kn, mit n = 255, benötigt werden. Für den Digitalwert 0 wird kein gesonderter Komparatorbaustein benötigt, so daß in der Praxis ein Baustein weniger als der Wertebereich des Digitalwerts erforderlich ist.

Die Komparatorbausteine K1 bis Kn sind jeweils an ihrem Referenzspannungseingang mit einem Spannungsabgriff eines Referenzspannungsteilers 8 verbunden, der aus einer Serienschaltung von n Widerständen R gebildet ist. An diesen werden die Referenzspannungen Ur1, Ur2, Ur3 bis Urn aus einer Referenzmutterspannung Ur erzeugt. Den Komparatorbausteinen K1 bis Kn ist jeweils an ihrem anderen Eingang die umzusetzende Spannung U zugeführt.

In jedem Komparator K1 bis Kn werden die Spannung U und die jeweilige Referenzspannung Ur1 bis Urn miteinander verglichen. Ist die Spannung U kleiner als die Referenzspannung Ur1 bis Urn, so erzeugt der betreffende Komparatorbaustein K1 bis Kn an seinem Ausgang eine Spannung, die dem Binärwert 0 entspricht. Ist die Spannung U gleich oder größer als die Referenzspannung Ur1 bis Urn, so erzeugt er eine Spannung, die dem Binärwert 1 entspricht.

Jeder Ausgang der Komparatorbausteine K1 bis Kn ist mit dem Setzeingang S eines RS-Flip-Flops F1 bis Fn verbunden. Die Rücksetzeingänge R der RS-Flip-Flops F1 bis Fn sind untereinander verbunden. Ihnen wird das Freigabesignal 22 zugeführt, das in einem Taktbaustein 10 erzeugt wird und das zum Rücksetzen der RS-Flip-Flops F1 bis Fn dient. Der Taktbaustein 10 wird über einen Bus 20 mit Signalen versorgt, die von einer nicht dargestellten übergeordneten Steuerung bereitgestellt werden.

Die Ausgänge der RS-Flip-Flops F1 bis Fn sind jeweils mit einem Eingang E1 bis En eines Encoderbausteins 12 verbunden. Dieser ist beispielsweise ein Prioritäts-Decoder, der aus einem 1-aus-n-Code einen Dualcode erzeugt. An seinem 8-Bit-Ausgang liegt nach der Umwandlung der Eingangssignale an den Eingängen El bis En ein Digitalwert an, der der höchsten Eingangsnummer seiner Eingänge El bis En entspricht, an der der Binärwert 1 anliegt. Der Wert der darunterliegenden Ausgangssignale der RS-Flip-Flops F1 bis Fn wird nicht berücksichtigt.

Der am Ausgang des Encoderbausteins 12 vorliegende Digitalwert wird über einen 8-Bit-Bus 16 an ein Register 14 weitergegeben und dort zwischengespeichert. Durch Signale des Taktbausteins 10 gesteuert, wird der Digitalwert auf einen Datenbus 18 ausgegeben und z.B. von der übergeordneten Steuerung weiterverarbeitet.

Im folgenden wird die Funktionsweise der Schaltungsanordnung nach Fig. 1 erläutert. Zu Beginn der Umsetzung werden durch das auf die Rücksetzeingänge der RS-Flip-Flops F1 bis Fn wirkende Freigabesignal 22 sämtliche Flip-Flops F1 bis Fn auf den Anfangszustand mit Binärwert O gesetzt. Dem Encoderbaustein 12 werden somit an seinen Eingängen E1 bis En nur Binärwerte 0 angeboten, so daß sein Ausgang den Digitalwert 0 anzeigt. Entsprechend der Höhe der Spannung U an den Eingängen der Komparatorbausteine K1 bis Kn schalten diejenigen Bausteine K1 bis Kn ihre Ausgänge auf den Binärwert 1 um, deren Referenzspannungen Ur1 bis Urn durch die Spannung U überschritten werden.

Da die Ausgänge dieser Komparatorbausteine K1 bis Kn direkt auf die Setzeingänge der RS-Flip-Flops F1 bis Fn wirken, kippen diese in den Binärzustand 1 und verharren in diesem, auch wenn sich der Binärwert des betreffenden Komparatorbausteins K1 bis Kn wieder nach 0 ändert. Das an den Ausgängen der Flip-Flops F1 bis Fn wiedergegebene Binärmuster, bestehend aus einer Gruppe mit Wert 1 und einer Gruppe mit Wert 0, bildet also den seit der Rücksetzung der Flip-Flops F1 bis Fn aufgetretenen höchsten Spannungswert U ab. Der Encoderbaustein 12 wandelt dieses Binärmuster in den Digitalwert mit einer Breite von 8 Bit um. Nach Ablauf der Zeit T liegt am Ausgang des Encoderbausteins 12 ein Digitalwert an, der den Spitzenwert der Spannung innerhalb des Zeitabschnitts T1 angibt, der sich vom Zeitpunkt der abfallenden Impulsflanke des Freigabesignals bis zum Zeitpunkt der ansteigenden Flanke des nächsten Impulses erstreckt. Der Digitalwert wird danach über den Datenbus 18 ausgegeben und durch das Freigabesignal 22 eine erneute Umsetzung gestartet.

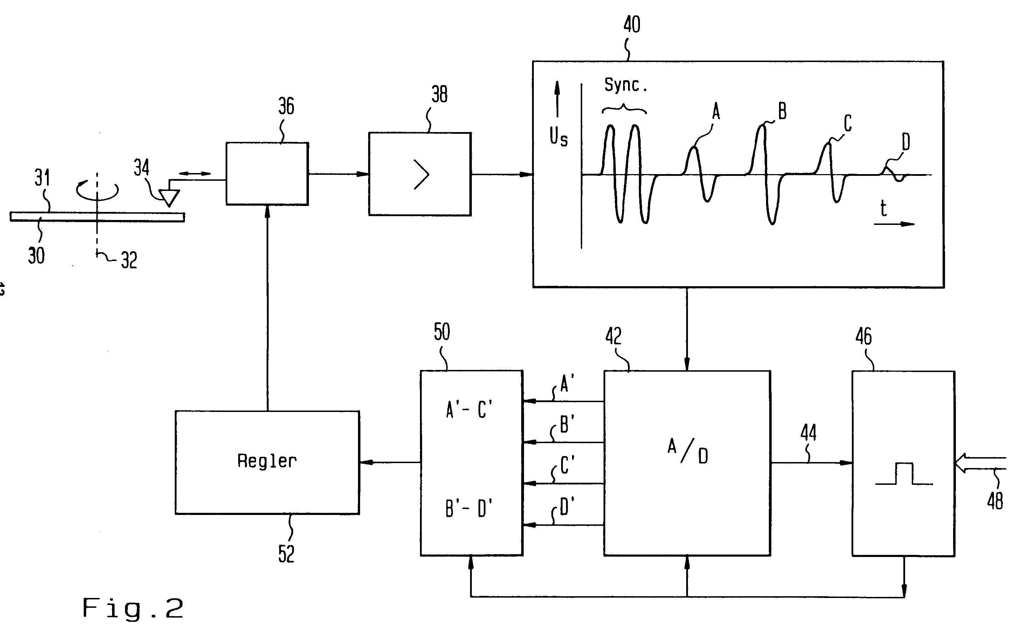

In Fig. 2 ist eine Anwendung der Erfindung bei der Spurregelung eines Magnetplatten-Speichersystems in einem Blockschaltbild dargestellt. Eine Magnetplatte 30 mit einer Servooberfläche 31 rotiert um eine Drehachse 32. Ein Servokopf 34 tastet die auf der Servooberfläche 31 kreisringförmig gespeicherten Positionsinformationen ab. Die Position des Servokopfes 34 ist durch einen Servoantrieb 36 radial zur Servooberfläche 31 veränderbar.

Die vom Servokopf 34 erzeugten Servosignale werden in einem Verstärker 38 verstärkt. Im Block 40 ist eine grafische Darstellung der Servosignale in Form einer Servospannung Us über der Zeit t wiedergegeben. Zur Spurlagereglung des Servokopfes 34 wird das bekannte Quadratur-Dibit-Verfahren verwendet. Bei diesem sind auf der Servooberfläche 31 in Form von Doppelflußwechseln Positionsmarken gespeichert, die gegeneinander so versetzt sind, daß sie Mittellinien von Magnetspuren definieren. Beim Abtasten der Positionsmarken durch den Servokopf 34 entstehen Spannungsimpulse, die im Block 40 mit Sync, A, B, C, D bezeichnet sind und die gemäß einem definierten Zeitraster verteilt sind. Die mit Sync im Block 40 bezeichneten Impulse dienen zur Synchronisation der nachfolgenden vier Impulse A, B, C und D, in denen die radiale Spurlageinformation enthalten ist.

Bei der Auswertung der Impulse Sync, A, B, C, D nach dem Quadratur-Dibit-Verfahren sind die Spitzenwerte dieser Spannungsimpulse zu ermitteln.

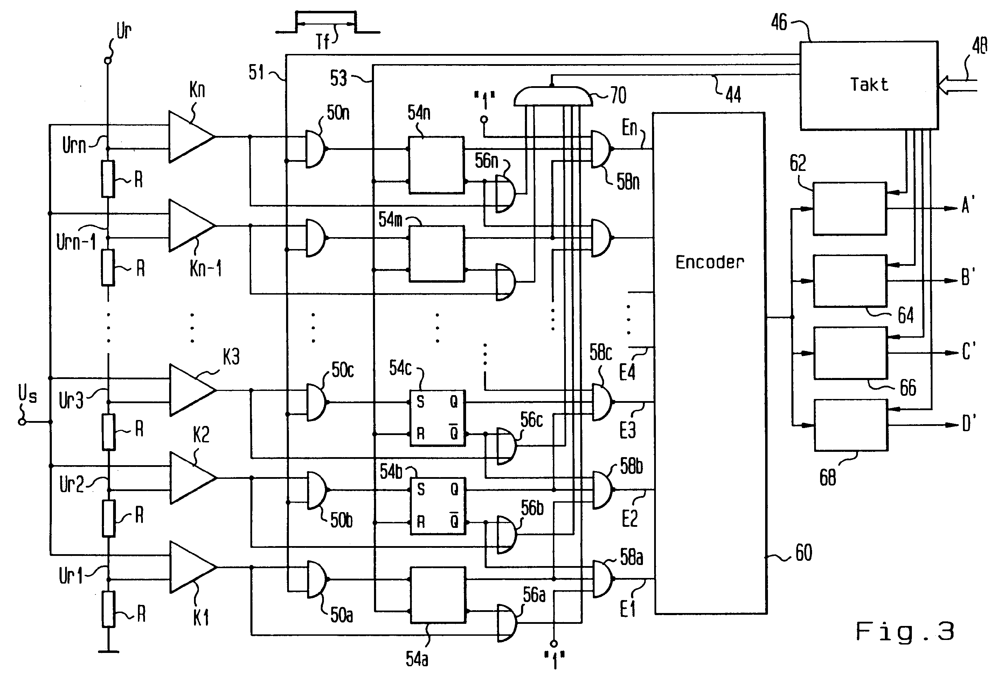

Zur Gewinnung dieser Spitzenwerte wird das erfindungsgemäße Verfahren eingesetzt. Die Servospannung Us wird einem A/D-Umsetzer 42 zugeführt, dessen Aufbau später bei der Beschreibung der Fig. 3 noch erläutert wird. Der Umsetzer 42 erzeugt ein Synchronisationssignal 44, das einem Taktgeber 46 zugeführt wird. Dieser wird von einer nicht dargestellten Steuerung über den Steuerbus 48 mit Signalen versorgt und steuert den Start der Umsetzung im Umsetzer 42 sowie die Ausgabe von Signalen eines Spurabweichungsdetektors 50.

Nach der Umsetzung liegen am Ausgang des A/D-Umsetzers 42 vier Digitalwerte A', B', C', D' vor, welche den Spannungsspitzenwerten der Impulse A, B, C, D entsprechen. Der digital arbeitende Spurabweichungsdetektor 50 berechnet die Differenzen der Digitalwerte A' - C' sowie B' - C'. Sind diese von Null verschieden, so liegt eine Spurabweichung vor, und ein Regler 52 wirkt auf den Servoantrieb 36 so ein, daß die Spurabweichung auf Null geregelt wird. Durch die schnelle Spitzenwertermittlung im Umsetzer 42 wird es möglich, einen Teil des Regelkreises zur Spurregelung bei einem Magnetplatten-Speichersystem digital auszuführen. Dadurch kann eine hohe Regelgenauigkeit sowie ein einfacheres Schaltungskonzept verwirklicht werden.

In Fig. 3 ist der A/D-Umsetzer 42 nach Fig. 2 näher dargestellt. Sein Aufbau entspricht eingangsseitig dem in Fig. 1 dargestellten, so daß dieser Teil nicht nochmals beschrieben werden muß. Der Umsetzer 42 enthält jedoch wichtige Zusatzfunktionen, die im folgenden genauer erläutert werden. Jeder Komparatorbaustein K1 bis Kn ist an seinem Ausgang mit dem einen Eingang eines NAND-Gliedes 50a bis 50n verbunden, an dessen anderen Eingang ein Fenstersignal 51 gelegt ist, das vom Taktgeber 46 erzeugt wird. Die Ausgänge der NAND-Glieder 50a bis 50n sind jeweils mit dem Setzeingang eines SR-Flip-Flops 54a bis 54n verbunden, während den Rücksetzeingängen R der Flip-Flops 54a bis 54n ein Freigabensignal 53 zugeführt ist.

Jedes RS-Flip-Flop 54a bis 54n ist an seinem nicht invertierenden Ausgang Q mit einem Eingang eines NAND-Gliedes 58a bis 58n, das drei Eingänge hat, verbunden. Ein weiterer Eingang des NAND-Gliedes 58a bis 58n ist mit dem invertierenden Ausgang des Flip-Flops 54b bis 54n verbunden, das über den Komparatorbaustein K1 bis Kn mit nächsthöherer Referenzspannung Ur1 bis Urn angesteuert wird. Der dritte Eingang des NAND-Gliedes 58a bis 58n ist mit dem nicht invertierenden Ausgang des Flip-Flops 54a bis 54n verbunden, das über den Komparatorbaustein K1 bis Kn mit nächstniedrigerer Referenzspannung Ur1 bis Urn angesteuert wird. Die nach der vorgenannten Verknüpfungsregel nicht belegbaren Eingänge der NAND-Glieder 58a bis 58n sind auf einen Spannungswert gelegt, der dem Binärwert 1 entspricht. Die Ausgänge aller NAND-Glieder 58a bis 58n werden jeweils mit einem Eingang E1 bis En eines Encoderbausteins 60 verbunden, der ein Prioritätsdecoder ist. Der 8-Bit-Ausgang des Encoderbausteins 60 ist mit den Eingängen von vier 8-Bit-Registern 62 bis 68 verbunden, die mit Taktimpulsen durch den Taktgeber 46 versorgt werden. An den Ausgängen der Register 62 bis 68 können die Digitalwerte A', B', C' sowie D' abgegriffen werden, die den Spitzenwerten der Impulse A, B, C, D der Servospannung Us in Fig. 2 entsprechen.

Die invertierenden Ausgänge der RS-Flip-Flops 54a bis 54n sind ferner jeweils mit einem Eingang eines ODER-Gliedes 56a bis 56n verbunden. Dessen weiterer Eingang ist mit dem Ausgang des das Flip-Flop 54a bis 54n steuernden Komparatorbausteins K1 bis Kn verbunden. Die Ausgänge der ODER-Glieder 56a bis 56n sind jeweils mit einem Eingang eines NAND-Gliedes 70 verbunden, an dessen Ausgang das Synchronisationssignal 44 erzeugt wird, das dem Taktgeber 46 zugeführt wird.

Im folgenden wird die Wirkungsweise der Schaltungsanordnung nach Fig. 3 erläutert. Ein Umsetzvorgang wird durch Ausgabe des Freigabesignals 53 gestartet, wobei sämtliche RS-Flip-Flops 54a bis 54n in den Anfangszustand gesetzt werden, bei dem die nicht invertierenden Ausgänge den Binärwert 0 haben. Da die Komparatorbausteine K1 bis Kn kontinuierlich arbeiten, liegen an ihren Ausgängen Binärwerte vor, die in ihrer Gesamtheit als Binärmuster laufend den Augenblickswert der Servospannung Us abbilden. Durch Ausgabe des Fenstersignals 51 mit dem Wert 1 wirken die Ausgänge der Komparatorbausteine K1 bis Kn über die NAND-Glieder 50a bis 50n jeweils direkt auf den Setzeingang des ihnen nachgeschalteten Flip-Flops 54a bis 54n, und das Binärmuster wird in die RS-Flip-Flops 54a bis 54n übernommen und dort gespeichert. Die Zeit Tf, in der das Fenstersignal 52 den Wert 1 hat, definiert das Zeitfenster, in dem der Spitzenwert der Spannung Us ermittelt wird.

Die ODER-Glieder 56a bis 56n sowie das NAND-Glied 70 dienen zum Erzeugen des Synchronisationssignals 44, mit dem der Zeitpunkt des Auftretens des Spitzenwerts festgestellt werden kann. Beim Ansteigen der Spannung Us bis zu ihrem Maximalwert werden diejenigen Ausgänge der Komparatorbausteine K1 bis Kn auf den Binärwert 1 gesetzt, deren Referenzspannungen Ur1 bis Urn die Spannung Us überschreitet. In diesem Zustand bleiben die Ausgänge, bis die Spannung Us wieder sinkt. Derjenige Komparatorbaustein, z.B. K2, dessen Referenzspannung Ur2 vom Spitzenwert der Spannung Us gerade noch überschritten worden ist, wird als erster an seinem Ausgang den Binärwert 0 abgeben. Dann haben beide Eingänge des ODER-Gliedes 56c den Binärwert 0 und demnach auch sein Ausgang. Demzufolge wird am Ausgang des NAND-Gliedes 70 das Synchronisationssignal 44 mit dem Binärwert 1 erzeugt. Das Synchronisationssignal 44 wird vom Taktgeber 46 verarbeitet, um die Zeitlage der Impulse Sync, A, B, C, D der Servospannung Us zu bestimmen.

Aufgrund unterschiedlicher Verarbeitungsgeschwindigkeiten der Komparatorbausteine K1 bis Kn sowie durch Signallaufzeiten kann der nicht invertierende Ausgang eines Flip-Flops 54a bis 54n gesetzt werden, obwohl das Flip-Flop 54a bis 54n mit nächstniedrigerem Referenzspannungswert Ur1 bis Urn noch nicht durchgeschaltet hat. Dadurch kann ein falsches Umsetzergebnis erzeugt werden. Dies wird durch die NAND-Glieder 58a bis 58n vermieden. Zum Beispiel schaltet das NAND-Glied 58b seinen Ausgang erst dann auf den Binärwert 0, wenn der nicht invertierende Ausgang des Flip-Flops 54a mit nächstniedrigerer Referenzspannung Ur1 den Binärwert 1 und der invertierende Ausgang des Flip-Flops 54c mit nächsthöherer Referenzspannung Ur3 den Binärwert 0 hat. Durch diese logische Verriegelung wird gewährleistet, daß im Binärmuster an den Eingängen El bis En des Encoderbausteins 60 keine fehlerhaften Binärwerte auftreten können und somit auch die Codewandlung in jedem Falle zum richtigen Digitalwert führt, der dem Spitzenwert der Spannung Us entspricht.

Die Impulse Sync, A, B, C und D stehen wie bereits erwähnt in einem festen zeitlichen Verhältnis zueinander. Entsprechend dem vorgegebenen Zeitraster steuert der Taktgeber 46 die Ausgabe der Signale 53, 51 sowie der Setzsignale für die Register 62 bis 68. Diese Art der Steuerung ist für das Quadratur-Dibit-Verfahren bekannt und muß hier nicht näher erläutert werden. Nach dem Ablauf mehrerer A/D-Umsetzungen sind an den Ausgängen der Register 62 bis 68 die Spitzenwerte A', B', C' und D' zur weiteren Verarbeitung im Regelkreis 52 zur Spurpositionierung gemäß Fig. 2 verfügbar.

## Patentansprüche

1. Verfahren zum Umsetzen einer analogen Spannung (U), insbesondere eines Servosignals eines Plattenspeichersystems, in einen Digitalwert, bei dem die Spannung (U) mit mehreren voneinander verschiedenen Referenzspannungen (Ur1 bis Urn) verglichen und abhängig vom jeweiligen Vergleich ein Binärwert erzeugt wird, der in jeweils einem durch ein Freigabesignal (22, 53) steuerbaren bistabilen Speicherbaustein (54a bis 54n) gespeichert wird, wonach die gespeicherten Binärwerte in den Digitalwert umgewandelt werden und dieser ausgegeben wird, wobei alle Speicherbausteine (54a bis 54n) zu Beginn der Umsetzung durch das Freigabesignal (22, 53) auf einen Anfangszustand gesetzt werden, **dadurch gekennzeichnet,** daß der beim jeweiligen Vergleich erzeugte Binärwert und der invertierte gespeicherte Binärwert disjunktiv verknüpft werden und daß die Ergebnisse der Verknüpfungen für alle Vergleiche konjunktiv zu einem Synchronisationssignal (44) verknüpft werden.

2. Verfahren nach Anspruch 1, **dadurch gekennzeichnet,** daß der Binärwert im Speicherbaustein (54a bis 54n) abhängig von einem Fenstersignal (51) gespeichert wird.

3. Verfahren nach einem der vorhergehenden Ansprüche, dadurch **gekennzeichnet,** daß jeder gespeicherte Binärwert mit dem gespeicherten Binärwert mit nächstniedrigerer Referenzspannung (Ur1 bis Urn) und mit dem invertierten gespeicherten Binärwert mit nächsthöherer Referenzspannung (Ur1 bis Urn) konjunktiv verknüpft wird und das Ergebnis für die Umwandlung in den Digitalwert verwendet wird, wobei der gespeicherte Binärwert mit niedrigster Referenzspannung (Ur1) nur mit dem invertierten gespeicherten Binärwert mit nächsthöherer Referenzspannung (Ur2) und der gespeicherte Binärwert mit höchster Referenzspannung (Urn) nur mit dem gespeicherten Binärwert mit nächstniedrigerer Referenzspannung (Urn-1) konjunktiv verknüpft wird.

4. Verfahren nach einem der vorhergehenden Ansprüche, dadurch **gekennzeichnet,** daß die umzusetzende analoge Spannung (Us) aus Servosignalen eines Plattenspeichersystems zur Spurlageregelung eines Servokopfes (34) erzeugt wird.

5. Verfahren nach Anspruch 4, dadurch **gekennzeichnet,** daß die Servosignale nach dem Quadratur-Dibit-Verfahren erzeugt werden.

6. Schaltungsanordnung zum Durchführen des Verfahrens nach einem der Ansprüche 1 bis 5, mit mehreren Komparatorbausteinen (K1 bis Kn), denen eine umzusetzende analoge Spannung (U) zugeführt wird und die voneinander verschiedene Referenzspannungen (Ur1 bis Urn) haben, mit denen die analoge Spannung (U) verglichen wird, und die abhängig vom jeweiligen Vergleich je einen Binärwert erzeugen, der jeweils einem durch ein Freigabesignal (22, 53) am Rücksetzeingang steuerbaren bistabilen Speicherbaustein (54a bis 54n) an seinem Setzeingang zugeführt wird, wobei die Ausgangssignale aller Speicherbausteine (54a bis 54n) einem Codewandler (12) zugeführt werden, der sie in einen Digitalwert umwandelt und diesen ausgibt, wobei alle Speicherbausteine (54a bis 54n) zu Beginn der Umsetzung durch das Freigabesignal (22, 53) auf einen Anfangszustand rücksetzbar sind, dadurch **gekennzeichnet,** daß jedem Komparatorbaustein (K1 bis Kn) ein ODER-Glied (56a bis 56n) nachgeschaltet ist, dessen einer Eingang mit dem Ausgang des jeweiligen Komparatorbausteins (K1 bis Kn) und dessen anderer Eingang mit dem invertierenden Ausgang des dem jeweiligen Komparatorbaustein (K1 bis Kn) nachgeschalteten Speicherbaustein (54a bis 54n) verbunden ist, und daß die Ausgänge aller ODER-Glieder (50a bis 50n) jeweils mit einem Eingang eines NAND-Gliedes (70) verbunden sind, das an seinem Ausgang ein Synchronisationssignal (44) abgibt.

7. Schaltungsanordnung nach Anspruch 6, dadurch **gekennzeichnet,** daß als Speicherbausteine (54a bis 54n) RS-Flip-Flops vorgesehen sind.

8. Schaltungsanordnung nach Anspruch 6 oder 7, dadurch **gekennzeichnet,** daß zwischen den Komparatorbausteinen (K1 bis Kn) und den Speicherbausteinen (54a bis 54n) jeweils ein NAND-Glied (50a bis 50n) geschaltet ist, dessen einer Eingang mit dem Ausgang des jeweiligen Komparatorbausteins (K1 bis Kn) verbunden ist und an dessen anderen Eingang ein Fenstersignal (51) zugeführt ist.

9. Schaltungsanordnung nach einem der Ansprüche 6 bis 8, dadurch **gekennzeichnet,** daß zwischen jeden Speicherbaustein (54a bis 54n) und den Codewandler (60) ein NAND-Glied (58a bis 58n) mit drei Eingängen geschaltet ist, dessen erster Eingang mit dem nicht invertierenden Ausgang des jeweiligen Speicherbausteins (54a bis 54n), dessen zweiter Eingang mit dem nicht invertierenden Ausgang des Speicherbausteins (54a bis 54m) mit nächstniedrigerer Referenzspannung (Ur1 bis Urn-1) und dessen dritter Eingang mit dem invertierenden Ausgang des Speicherbausteins (54b bis 54n) mit nächsthöherer Referenzspannung (Ur2 bis Urn) verbunden ist, wobei der dritte Eingang des dem Speicherbaustein (Kn) mit höchster Referenzspannung (Urn) nachgeschalteten NAND-Gliedes (58n) sowie der zweite Eingang des dem Speicherbaustein (K1) mit niedrigster Referenzspannung (Ur1) nachgeschalteten NAND-Gliedes (58a) jeweils an einen Spannungspegel mit Logikpegel 1 gelegt wird.

## Claims

1. Method for converting an analog voltage (U), especially a servo signal of a disk memory system, into a digital value, in which the voltage (U) is compared with a plurality of mutually different reference voltages (Ur1 to Urn) and, depending on the respective comparison, a binary value is produced, which is stored in each case in one bistable memory element (54a to 54n) which can be controlled by an enabling signal (22, 53), after which the stored binary values are converted into the digital value and the latter is emitted, the enabling signal (22, 53) setting all the memory elements (54a to 54n) to an initial state at the start of the conversion, characterized in that the binary value produced in the respective comparison and the inverted stored binary value are OR-linked, and in that the results of the links for all the comparisons are AND-linked to form a synchronization signal (44).

2. Method according to Claim 1, characterized in that the binary value is stored in the memory element (54a to 54n) as a function of a window signal (51).

3. Method according to one of the preceding claims, characterized in that each stored binary value is AND-linked to the stored binary value having the next-lower reference voltage (Ur1 to Urn) and to the inverted stored binary value having the next-higher reference voltage (Ur1 to Urn), and the result is used for the conversion into the digital value, the stored binary value having the lowest reference voltage (Ur1) being AND-linked only to the inverted stored binary value having the next-higher reference voltage (Ur2), and the stored binary value having the highest reference voltage (Urn) being AND-linked only to the stored binary value having the next-lower reference voltage (Urn-1).

4. Method according to one of the preceding claims, characterized in that the analog voltage (Us) to be converted is produced from servo signals from a disk storage system in order to control the track position of a servo head (34).

5. Method according to Claim 4, characterized in that the servo signals are produced using the quadrature dibit method.

6. Circuit arrangement for carrying out the method according to one of Claims 1 to 5, having a plurality of comparator elements (K1 to Kn), to which an analog voltage (U) to be converted is supplied, and which have mutually different reference voltages (Ur1 to Urn), with which the analog voltage (U) is compared, and which each produce a binary value, as a function of the respective comparison, which is supplied in each case to the set input of a bistable memory element (54a to 54n), which can be controlled by an enabling signal (22, 53) at the reset input, the output signals of all the memory elements (54a to 54n) being supplied to a code converter (12) which converts them into a digital value and emits said digital value, the enabling signal (22, 53) being capable of resetting all the memory elements (54a to 54n) to an initial state at the start of the conversion, characterized in that an OR-gate (56a to 56n) is connected to the output side of each comparator element (K1 to Kn), one input of which OR-gate is connected to the output of the respective comparator element (K1 to Kn), its other input being connected to the inverting output of the memory element (54a to 54n) which is connected to the output of the respective comparator element (K1 to Kn), and in that the outputs of all the OR-gates (50a to 50n) are connected in each case to one input of a NAND-gate (70) which emits a synchronization signal (44) at its output.

7. Circuit arrangement according to Claim 6, characterized in that RS flipflops are provided as the memory elements (54a to 54n).

8. Circuit arrangement according to Claim 6 or 7, characterized in that a NAND-gate (50a to 50n) is connected in each case between the comparator elements (K1 to Kn) and the memory elements (54a to 54n), one input of which NAND-gate is connected to the output of the respective comparator element (K1 to Kn), the window signal (51) being supplied to its other input.

9. Circuit arrangement according to one of Claims 6 to 8, characterized in that a NAND-gate (58a to 58n) having three inputs is connected between each memory element (54a to 54n) and the code converter (60), the first input of which NAND-gate is connected to the non-inverting output of the respective memory element (54a to 54n), its second input being connected to the non-inverting output of the memory element (54a to 54m) having the next-lower reference voltage (Ur1 to Urn-1), and its third input being connected to the inverting output of memory element (54b to 54n) having the next-higher reference voltage (Ur2 to Urn), the third input of the NAND-gate (58n) which is connected to the output of the memory element (Kn) having the highest reference voltage (Urn), and the second input of the NAND-gate (58a) which is connected to the output of the memory element (K1) having the lowest reference voltage (Ur1) being connected in each case to a voltage level at logic level 1.

## Revendications

1. Procédé de conversion d'une tension analogique (U), notamment d'un signal de servocommande d'un système de mémoire à disques, en une valeur numérique, selon lequel la tension (U) est comparée à plusieurs tensions de référence différentes (Ur1 à Urn), et en fonction de la comparaison respective, est produite une valeur binaire, qui est mémorisée dans un module bistable de mémoire (54a à 54n), qui peut être commandé par un signal de libération (22,53), à la suite de quoi les valeurs binaires mémorisées sont converties en la valeur numérique et cette valeur numérique est délivrée, tous les modules de mémoire (54a à 54n) étant positionnés dans un état initial au début de la conversion, par le signal de libération (22,53), caractérisé par le fait que la valeur binaire obtenue lors de la comparaison respective et la valeur binaire mémorisée inversée sont combinées selon la combinaison OU et que les résultats des combinaisons pour toutes les comparaisons sont combinés selon la combinaison ET pour former un signal de synchronisation (44).

2. Procédé suivant la revendication 1, caractérisé par le fait que la valeur binaire est mémorisée dans le module de mémoire (54a à 54n) en fonction d'un signal de fenêtre (51).

3. Procédé suivant l'une des revendications précédentes, caractérisé par le fait que chaque valeur binaire mémorisée est combinée selon la combinaison ET à la valeur binaire mémorisée associée à la tension de référence (Ur1 à Urn) immédiatement inférieure et à la valeur binaire mémorisée inversée associée à la tension de référence (Ur1 à Urn) immédiatement supérieure et que le résultat est utilisé pour la conversion à la valeur numérique, la valeur binaire mémorisée associée à la tension de référence la plus faible (Ur1) étant combinée selon la combinaison ET uniquement à la valeur binaire mémorisée inversée associée à la tension de référence immédiatement supérieure (Ur2), tandis que la valeur binaire mémorisée associée à la tension de référence la plus élevée (Urn) est combinée selon une combinaison ET uniquement à la valeur binaire mémorisée associée à la tension de référence immédiatement inférieure (Urn-1).

4. Procédé suivant l'une des revendications précédentes, caractérisé par le fait que la tension analogique (Us) devant être convertie est produite à partir de signaux d'asservissement d'un système de mémoire à disques pour le réglage de la position de piste d'une tête de servocommande (34).

5. Procédé suivant la revendication 4, caratérisé par le fait que les signaux de servocommande sont produits selon le procédé Dibit en quadrature.

6. Procédé suivant l'une des revendications 1 à 5, comportant plusieurs modules comparateurs (K1 à Kn), auxquels est envoyée une tension analogique (U) devant être convertie et qui possèdent les tensions de référence (Ur1 à Urn) différentes, auxquelles la tension analogique (U) est comparée, et qui produisent, en fonction de la comparaison respective, respectivement une valeur binaire qui est envoyée à l'entrée de positionnement respectivement d'un module bistable de mémoire (54a à 54n) pouvant être commandé par un signal de libération (22,53) appliqué à son entrée de remise à l'état initial, les signaux de sortie de tous les modules de mémoire (54a à 54n) étant envoyés à un convertisseur de code (12), qui les convertit en une valeur numérique et les délivre, tous les modules de mémoire (54a à 54n) pouvant être ramenés à l'état initial au debut de la conversion, au moyen du signal de libération (22,53), caractérisé par le fait qu'en aval de chaque module comparateur (K1 à Kn) est branché un circuit OU (56a à 56n), dont une entrée est raccordée à la sortie du module comparateur respectif (K1 à Kn) et dont l'autre entrée est raccordée à la sortie inverseuse du module de mémoire (54a à 54n) branché en aval du module comparateur respectif (K1 à Kn), et que les sorties de tous les circuits OU (50a à 50n) sont reliées respectivement à une entrée d'un circuit NON-ET (70), qui délivre à sa sortie un signal de synchronisation (14).

7. Montage suivant la revendication 6, caractérisé par le fait que des bascules bistables de type RS sont prévues en tant que modules de mémoire (54a à 54n).

8. Montage suivant la revendication 6 ou 7, caractérisé par le fait qu'entre les modules comparateurs (K1 à Kn) et les modules de mémoire (54a à 54n) est branché respectivement un circuit NON-ET (50a à 50n), dont une entrée est connectée à la sortie du module comparateur respectif (K1 à Kn) et à l'autre entrée duquel est envoyé un signal de fenêtre (51).

9. Montage suivant l'une des revendications 6 à 8, caractérisé par le fait qu'entre chaque module de mémoire (54a à 54n) et le convertisseur de code (60) est branché un circuit NON-ET (58a à 58n) comportant trois entrées, dont la première est reliée à l'entrée non inverseuse du module de mémoire respectif (54a à 54n), dont la seconde entrée est reliée à la sortie non inverseuse du module de mémoire (54a à 54m) auquel est associée la tension de référence (Ur1 à Urn-1) immédiatement inférieure et dont la troisième entrée est reliée à la sortie inverseuse du module de mémoire (54b à 54n) auquel est associée la tension de référence (Ur2 à Urn) immédiatement supérieure, la troisième entrée du circuit NON-ET (58n), qui est branchée en aval du module de mémoire (Kn) auquel est associée la tension de référence maximale (Urn), ainsi que la seconde entrée du circuit NON-ET (58a) branchée en aval du module de mémoire (K1) auquel est associée la tension de référence (Ur1) la plus faible, étant placées respectivement à un niveau de tension possédant la valeur logique 1.
